# EUROPÄISCHE PATENTSCHRIFT

(11) **EP 2 903 027 B1**
(45) Veröffentlichungstag und Bekanntmachung des Hinweises auf die Patenterteilung: **22.08.2018**
(21) Anmeldenummer: 14000357.5
(22) Anmeldetag: 30.01.2014
(51) Int. Cl.: H01L 29/45, H01L 33/02, H01L 33/14, H01L 33/06, H01L 33/30, H01L 33/40

(54) **LED-Halbleiterbauelement**
LED semiconductor component
Composant semi-conducteur à DEL

(43) Veröffentlichungstag der Anmeldung: 05.08.2015
(73) Patentinhaber: AZUR SPACE Solar Power GmbH, 74072 Heilbronn (DE)
(72) Erfinder: Fuhrmann, Daniel, 74074 Heilbronn (DE); Dunzer, Florian, 74074 Heilbronn (DE)
(74) Vertreter: Koch Müller Patentanwaltsgesellschaft mbH

(56) Entgegenhaltungen:
- EP-A1- 0 987 770
- DE-A1- 10 253 160
- DE-A1-102010 014 667
- JP-A- 2000 101 133
- US-A- 4 590 501
- US-A1- 2007 075 327

## Beschreibung

Die Erfindung betrifft ein LED-Halbleiterbauelement gemäß dem Oberbegriff des Patentanspruchs 1.

Aus der DE 10 2007 057 674 A1, der DE 102 11 531 B4, der US 8 330 174 B2, US 7 151 307 sind LED-Halbleiterbauelemente bekannt. Des Weiteren sind aus Y, Yu et al, Vacuum 69 (2003) 489-493, aus M. D'Hondt et al, Journal of Crystal Growth 195 (1998) 655-639 und aus H. Jifang et al, Journal of Semiconductor 2011, 32 (4) weitere LED Strukturen bekannt. Des Weiteren sind aus der DE 102 53 160 A1, der JP 2000 101 133 A, der US 2007 / 075327 A1, der EP 0 987 770 A1 und der DE 10 2010 01 4667 A1 weitere LED-Halbleiterbauelemente bekannt.

Vor diesem Hintergrund besteht die Aufgabe der Erfindung darin, eine Vorrichtung anzugeben, die den Stand der Technik weiterbildet.

Die Aufgabe wird durch ein LED-Halbleiterbauelement mit den Merkmalen des Patentanspruchs 1 gelöst. Vorteilhafte Ausgestaltungen der Erfindung sind Gegenstand von Unteransprüchen

Gemäß dem Gegenstand der Erfindung wird ein LED-Halbleiterbauelement bereitgestellt, mit einer n-dotierten Substratschicht, und einer ersten n-dotierten Mantelschicht, wobei die Mantelschicht auf der Substratschicht angeordnet ist, und einer aktiven Schicht, wobei die aktive Schicht eine lichtemittierende Schicht umfasst und auf der ersten Mantelschicht angeordnet ist, und einer zweiten p-dotierten Mantelschicht, wobei die zweite Mantelschicht auf der aktiven Schicht angeordnet ist, und einer p-dotierten Stromaufweitungsschicht, wobei die Stromaufweitungsschicht auf der zweiten Mantelschicht angeordnet ist, und einer p-dotierten Kontaktschicht, wobei die p-dotierte Kontaktschicht auf der Stromaufweitungsschicht angeordnet ist, wobei die p-dotierte Kontaktschicht aus einer aluminiumhaltigen Schicht besteht und als Dotierstoff Kohlenstoff aufweist. Es versteht sich, dass für eine handelsübliche LED die vorgenannte Schichtstruktur im Allgemeinen gehäust und mit elektrischen Anschlüssen versehen ist. Ferner sei angemerkt, dass sich in überraschender Weise durch ein Erhöhen des Aluminiumgehaltes der obersten
ten Schicht auch die Kohlenstoffdotierung steigern lässt -und hierbei die Bauelementeigenschaften sich verbessern.

Ein Vorteil der erfindungsgemäßen Vorrichtung ist es, dass durch die erfindungsgemäße Ausgestaltung die Lichtausbeute steigt und die Vorwärtsspannung der LED sinkt. Hierdurch wird der Wirkungsrad gesteigert und die Herstellung vereinfacht. Des Weiteren sinken die Herstellungskosten.

In einer Weiterbildung ist in der Kontaktschicht die Konzentration von Aluminium höher als in der Stromaufweitungsschicht ausgebildet. Vorzugsweise besteht die Kontaktschicht aus AlxGa1-xAs und weist hierbei ein AluminiumGehalt von x > 0.1 auf.

In einer Ausführungsform ist die Kohlenstoff Konzentration der Kontaktschicht größer als 2,5 x 10¹⁹. Untersuchungen haben gezeigt, dass die Dicke der Kontaktschicht kleiner als 100 nm ausreichend ist. Besonders Vorteilhaft lässt sich die erfindungsgemäße Ausgestaltung verwenden, wenn die auf der Substratschicht angeordneten Mantelschichten und Stromaufweitungsschicht jeweils eine AlGaAs-Verbindung umfassen. Besonders vorteilhaft ist es, wenn die Substratschicht Germanium oder GaAs umfasst oder aus GaAs oder Germanium besteht. Es versteht sich, dass die Substratschicht jeweils dotiert wird. Vorzugsweise ist die Substratschicht n-dotiert.

In einer Weiterbildung ist die lichtemittierende Schicht derart ausgebildet, dass von der Schicht Licht im infraroten Spektralbereich emittiert wird. Vorzugsweise emittiert die Schicht Licht im Spektralbereich zwischen 750 nm und 1000 nm. Untersuchungen haben gezeigt, dass es besonders vorteilhaft ist, wenn die lichtemittierende Schicht eine Vielfachquantentopfstruktur umfasst. Insbesondere umfasst die Vielfachquantentopfstruktur eine Verbindung aus GaAs und / oder AlGaAs und/ oder InGaAs und/ oder GaAsP und/ oder InGaAsP und / oder InAIGaAs. Des Weiteren sei angemerkt, dass die Stromaufweitungsschicht eine andere chemische Zusammensetzung als die zweite Mantelschicht aufweist. Keinesfalls lassen sich die beiden Schichten als eine einzige homogene Schicht ausbilden. Vorzugsweise weist die Stromaufweltungsschicht auch eine andere Schichtdicke als die zweite Mantelschicht auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Darin zeigt:
- Figur 1: einen Querschnitt eines Schichtaufbaus,
- Figur 2: ein Verlauf einer Aluminiumkonzentration in den beiden obersten Schichten des Schichtaufbaus, dargestellt in der Figur 1,
- Figur 3: ein Verlauf der Dotierstoffkonzentration in den beiden obersten Schichten des Schichtaufbaus, dargestellt in der Figur 1.

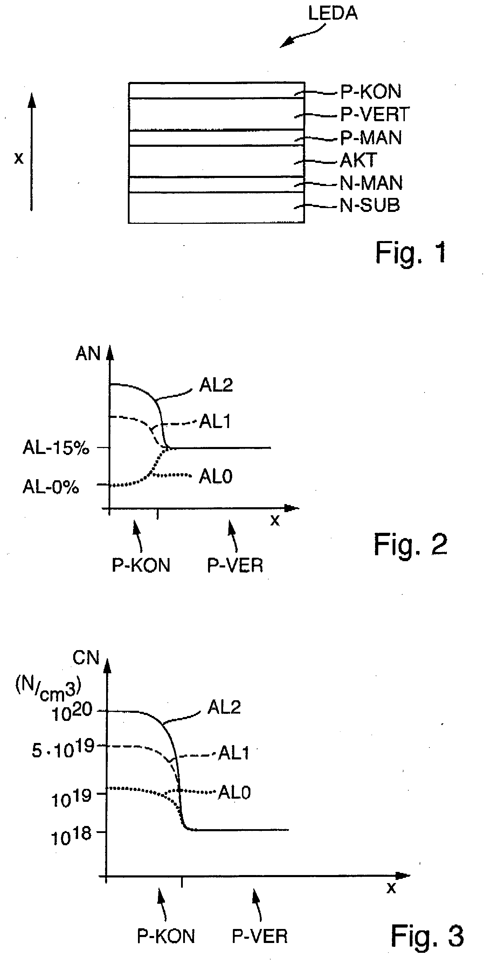

Die Abbildung der Figur 1 zeigt einen Querschnitt eines Schichtaufbaus eines LED-Halbleiterbauelement LEDA mit einer n-dotierten Substratschicht N-SUB, wobei die Substratschicht N-SUB eine Germanium oder eine GaAs Verbindung umfasst. Auf der n-dotierten Substratschicht N-SUB ist eine n-dotierte Mantelschicht N-MAN ausgebildet, wobei die Mantelschicht N-MAN insbesondere stoffschlüssig auf der Substratschicht N-SUB angeordnet ist. Auf der Mantelschicht N-MAN ist eine aktive Schicht AKT ausgebildet, wobei die aktive Schicht eine lichtemittierende Schicht umfasst und vorzugsweise stoffschlüssig auf der ersten Mantelschicht N-MAN angeordnet ist. Die lichtemittierende Schicht umfasst eine Vielfachquantentopfstruktur - nicht dargestellt. Auf der aktiven Schicht AKT Ist eine zweite p-dotierte Mantelschicht P-MAN ausgebildet, wobei die zweite Mantelschicht P-MAN stoffschlüssig mit der aktiven Schicht AKT verbunden ist. Auf der zweiten Mantelschicht P-MAN ist eine p-dotierte Stromaufweitungsschicht P-VERT, wobei die Stromaufweitungsschicht P-VERT stoffschlüssig mit der zweiten Mantelschicht P-MAN verbunden Ist. Auf der Stromaufweitungsschicht P-VERT ist eine p-dotierte Kontaktschicht P-KON angeordnet, wobei die p-dotierte Kontaktschicht P-KON stoffschlüssig mit der Stromaufweitungsschicht P-VERT verbunden ist. Hierbei besteht die p-dotierte Kontaktschicht P-KON aus einer aluminiumhaltigen Schicht und weist als Dotierstoff Kohlenstoff auf.

In der Abbildung der Figur 2 sind beispielhafte Verläufe von Aluminiumkonzentrationen AN in den beiden obersten Schichten, d.h. der Kontaktschicht P-KON und der Stromaufweitungsschicht P-VERT, des Schichtaufbaus dargestellt In der Figur 1 angeführt. Im Folgenden werden nur die Unterschiede zu der Abbildung der Figur 1 erläutert. Der Verlauf der Aluminiumkonzentration AN gemäß dem Stand der Technik ist mit einer gepunkteten Kurve AL0 beispielhaft wiedergegeben. Es zeigt sich dass, ausgehend von einer Konzentration von 15% In der Stromaufweitungsschicht P-VERT die Aluminiumkonzentration AN schnell unterhalb der Nachweisgrenze abfällt. Aus Gründen der Übersichtlichkeit ist die Nachweisgrenze mit 0% dargestellt. Demgegenüber steigt gemäß einer gestrichelten Kurve AL1 in der erfindungsgemäßen Kontaktschicht P-KON die Aluminiumkonzentration AN auf Werte oberhalb 15% an. In einer weiteren dargestellten Ausführungsform steigt gemäß einer durchgezogenen Kurve AL2 die Aluminiumkonzentration AN in der Kontaktschicht P-KON noch stärker als in der Kurve AL1 an.

In der Abbildung der Figur 3 sind beispielhafte Verläufe von Dotierstoffkonzentrationen CN in den beiden obersten Schichten, d.h. für die Kontaktschicht P-KON und Stromaufweitungsschicht P-VERT, des Schichtaufbaus, dargestellt in der Figur 1, angeführt. Im Folgenden werden nur die Unterschiede zu der Abbildung der Figur 1 und der Figur 2 erläutert. In einem gepunkteten Verlauf ist die Dotierstoffkonzentration CN gemäß dem Stand der Technik für die Kurve AL0 beispielhaft wiedergegeben. Es zeigt sich dass, ausgehend von einer Konzentration von etwa 10¹⁸ N/cm³ In der Stromaufweitungsschicht P-VERT die Dotierstoffkonzentration CN schnell auf Werte knapp oberhalb 10¹⁹ N/cm³ ansteigt. Demgegenüber steigt gemäß der gestrichelten Kurve AL1 in der erfindungsgemäßen Kontaktschicht P-KON die Dotierstoffkonzentration CN auf Werte oberhalb der Werte des Standes der Technik an, wobei vorzugsweise Werte von etwa 5 x 10¹⁹ N/cm³ erreicht werden. In einer weiteren dargestellten Ausführungsform steigt gemäß der durchgezogenen Kurve AL2 die Dotierstoffkonzentration CN in der Kontaktschicht P-KON noch stärker an als in der Kurve AL1, wobei vorzugsweise Werte bis etwa 2 x 10²⁰ N/cm³ erreicht werden. Es sei angemerkt, dass vorliegend im Unterschied zu dem Stand der Technik nicht Zn sondern C, also Kohlenstoff, als Dotierstoff verwendet wird.

## Patentansprüche

1. LED-Halbleiterbauelement (LEDA) mit
- einer n-dotierten Substratschicht (N-SUB), und
- einer ersten n-dotierten Mantelschicht (N-MAN), wobei die Mantelschicht (N-MAN) auf der Substratschicht (SUB) angeordnet ist, und einer aktiven Schicht (AKT), wobei die aktive Schicht (AKT) eine lichtemittierende Schicht (AKT) umfasst und auf der ersten Mantelschicht (N-MAN) angeordnet ist,
- einer zweiten p-dotierten Mantelschicht (P-MAN), wobei die zweite Mantelschicht (P-MAN) auf der aktiven Schicht angeordnet ist, und
- einer p-dotierten Stromaufweitungsschicht (P-VERT), wobei die Stromaufweitungsschicht (P-VERT) auf der zweiten Mantelschicht (P-MAN) angeordnet ist, und
- einer p-dotierten Kontaktschicht (P-KON), wobei die p-dotierte Kontaktschicht (P-KON) auf der Stromaufweitungsschicht (P-VERT) argeordnet ist, wobei die p-dotierte Kontaktschicht (P-KON) aus einer aluminiumhaltigen Schicht besteht und als Dotierstoff Kohlenstoff aufweist, und wobei in der Kontaktschicht (P-KON) die Konzentration von Aluminium höher als in der Stromaufweitungsschicht (P-VERT) ist, und die auf der Substratschicht (SUB) angeordneten Mantelschichten (N-MAN, P-MAN) und die Stromaufweitungsschicht (P-VERT) jeweils eine AlGaAs-Verbindung umfassen.

2. LED- Halbleiterbauelement (LEDA) nach Anspruch 1, **dadurch gekennzeichnet, dass** die Kontaktschicht (P-KON) aus AlxGal-xAs besteht und einen Al-Gehalt von x > 0.1 aufweist.

3. LED- Halbleiterbauelement (LEDA) nach einem der vorstehenden Ansprüche, **dadurch gekennzeichnet, dass** die Kohlenstoff Konzentration der Kontaktschicht (P-KON) größer als 2,5 x 10e19 ist.

4. LED- Halbleiterbauelement (LEDA) nach einem der vorstehenden Ansprüche, **dadurch gekennzeichnet, dass** die Dicke der Kontaktschicht (P-KON) kleiner als 100 nm ist.

5. LED- Halbleiterbauelement (LEDA) nach einem der vorstehenden Ansprüche, **dadurch gekennzeichnet, dass** die Substratschicht (SUB) Germanium oder Galliumarsenid umfasst.

6. LED- Halbleiterbauelement (LEDA) nach einem der vorstehenden Ansprüche, **dadurch gekennzeichnet, dass** die lichtemittierende Schicht Licht im infraroten Spektralbereich emittiert.

7. LED- Halbleiterbauelement (LEDA) nach einem der vorstehenden Ansprüche, **dadurch gekennzeichnet, dass** die lichtemittierende Schicht Licht im Spektralbereich zwischen 750 nm und 1000 nm emittiert.

8. LED- Halbleiterbauelement (LEDA) nach einem der vorstehenden Ansprüche, **dadurch gekennzeichnet, dass** die lichtemittierende Schicht eine Vielfachquantentopfstruktur umfasst.

9. LED- Halbleiterbauelement (LEDA) nach Anspruch 8, **dadurch gekennzeichnet, dass** die Vielfachquantentopfstruktur eine GaAs und / oder AlGaAs und / oder InGaAs und / oder GaAsP und / oder InGaAsP und / oder InAlGaAs Verbindung umfasst.

10. LED- Halbleiterbauelement (LEDA) nach einem der vorstehenden Ansprüche, **dadurch gekennzeichnet, dass** die Stromaufweitungsschicht (P-VERT) eine andere chemische Zusammensetzung aufweist, als die zweite Mantelschicht (P-MAN).

## Claims

1. LED semiconductor component (LEDA) comprising
- an n-doped substrate layer (N-SUB),
- a first, n-doped casing layer (N-MAN), wherein the casing layer (N-MAN) is arranged on the substrate layer (SUB) and an active layer (AKT), wherein the active layer (AKT) comprises a light-emitting layer (AKT) and is arranged on the first casing layer (N-MAN),
- a second, p-doped casing layer (P-MAN), wherein the second casing layer (P-MAN) is arranged on the active layer,
- a p-doped current expansion layer (P-VERT), wherein the current expansion layer (P-VERT) is arranged on the second casing layer (P-MAN), and
- a p-doped contact layer (P-KON), wherein the p-doped contact layer (P-KON) is arranged on the current expansion layer (P-VERT), wherein the p-doped contact layer (P-KON) consists of a layer with aluminium content and has carbon as doping substance, and wherein the concentration of aluminium is higher in the contact layer (P-KON) than in the current expansion layer (P-VERT) and the casing layers (N-MAN, P-MAN), which are arranged on the substrate layer (SUB), and the current expansion layer (P-VERT) each comprise an AlGaAs compound.

2. LED semiconductor component (LEDA) according to claim 1, **characterised in that** the contact layer (P-KON) consists of AlxGa1-xAs and has an Al content of x > 0.1.

3. Led semiconductor component (LEDA) according to one of the preceding claims, **characterised in that** the carbon concentration of the contact layer (P-KON) is greater than 2.5 x 10e19.

4. LED semiconductor component (LEDA) according to any one of the preceding claims, **characterised in that** the thickness of the contact layer (P-KON) is smaller than 100 nm.

5. LED semiconductor component (LEDA) according to any one of the preceding claims, **characterised in that** the substrate layer (SUB) comprises germanium or gallium arsenide.

6. LED semiconductor component (LEDA) according to any one of the preceding claims, **characterised in that** the light-emitting layer emits light in the infrared spectral region.

7. LED semiconductor component (LEDA) according to any one of the preceding claims, **characterised in that** the light-emitting layer emits light in the spectral region between 750 nm and 1,000 nm.

8. LED semiconductor component (LEDA) according to any one of the preceding claims, **characterised in that** the light-emitting layer comprises a multiple quantum well structure.

9. LED semiconductor component (LEDA) according to claim 8, **characterised in that** the multiple quantum well structure comprises a GaAs and/or AIGaAs and/or InGaAs and/or GaAsP and/or InGaAsP and/or InAIGaAs compound.

10. LED semiconductor component (LEDA) according to any one of the preceding claims, **characterised in that** the current expansion layer (P-VERT) has a different chemical composition from the second casing layer (P-MAN),

## Revendications

1. Composant semi-conducteur à DEL (LEDA) avec
- une couche de substrat à dopage n (N-SUB) et
- une première couche d'enveloppe à dopage n (N-MAN), dans lequel la couche d'enveloppe (N-MAN) est disposée sur la couche de substrat (SUB), et
- une couche active (AKT), dans lequel la couche active (AKT) comprend une couche électroluminescente (AKT) et est disposée sur la première couche d'enveloppe (N-MAN),
- une deuxième couche d'enveloppe à dopage p (P-MAN), dans lequel la deuxième couche d'enveloppe (P-MAN) est disposée sur la couche active, et
- une couche de diffusion de courant à dopage p (P-VERT), dans lequel la couche de diffusion de courant (P-VERT) est disposée sur la deuxième couche d'enveloppe (P-MAN), et
- une couche de contact à dopage p (P-KON), dans lequel la couche de contact à dopage p (P-KON) est disposée sur la couche de diffusion de courant (P-VERT), dans lequel la couche de contact à dopage p (P-KON) se compose d'une couche contenant de l'aluminium et présente du carbone comme substance dopante, et la concentration en aluminium est plus élevée dans la couche de contact (P-KON) que dans la couche de diffusion de courant (P-VERT), et les couches d'enveloppe (N-MAN, P-MAN) disposées sur la couche de substrat (SUB) et la couche de diffusion de courant (P-VERT) comprennent respectivement un composé AlGaAs.

2. Composant semi-conducteur à DEL (LEDA) selon la revendication 1, **caractérisé en ce que** la couche de contact (P-KON) se compose de AlxGal-xAs et présente une teneur en Al de x > 0,1.

3. Composant semi-conducteur à DEL (LEDA) selon l'une quelconque des revendications précédentes, **caractérisé en ce que** la concentration en carbone de la couche de contact (P-KON) est supérieure à 2,5 x 10e19.

4. Composant semi-conducteur à DEL (LEDA) selon l'une quelconque des revendications précédentes, **caractérisé en ce que** l'épaisseur de la couche de contact (P-KON) est inférieure à 100 nm.

5. Composant semi-conducteur à DEL (LEDA) selon l'une quelconque des revendications précédentes, **caractérisé en ce que** la couche de substrat (SUB) comprend du germanium ou de l'arséniure de gallium.

6. Composant semi-conducteur à DEL (LEDA) selon l'une quelconque des revendications précédentes, **caractérisé en ce que** la couche électroluminescente émet de la lumière dans le domaine spectral infrarouge.

7. Composant semi-conducteur à DEL (LEDA) selon l'une quelconque des revendications précédentes, **caractérisé en ce que** la couche électroluminescente émet de la lumière dans le domaine spectral entre 750 nm et 1 000 nm.

8. Composant semi-conducteur à DEL (LEDA) selon l'une quelconque des revendications précédentes, **caractérisé en ce que** la couche électroluminescente comprend une structure à puits quantiques multiples.

9. Composant semi-conducteur à DEL (LEDA) selon la revendication 8, **caractérisé en ce que** la structure à puits quantiques multiples comprend un composé GaAs et/ou AlGaAs et/ou InGaAs et/ou GaAsP et/ou InGaAsP et/ou InAlGaAs.

10. Composant semi-conducteur à DEL (LEDA) selon l'une quelconque des revendications précédentes, **caractérisé en ce que** la couche de diffusion de courant (P-VERT) présente une autre composition chimique que la deuxième couche d'enveloppe (P-MAN).
